Europäisches Patentamt

European Patent Office

Office européen des brevets

(19)

(11) EP 0 228 815 B2

(12) # NEW EUROPEAN PATENT SPECIFICATION

(45) Date of publication and mention
of the opposition decision:
**15.10.1997 Bulletin 1997/42**

(45) Mention of the grant of the patent:
**15.07.1992 Bulletin 1992/29**

(21) Application number: **86309266.4**

(22) Date of filing: **27.11.1986**

(51) Int Cl.6: **H01L 29/78**, H01L 29/08

(54) **Field effect transistors**

Feldeffekttransistor

Transistor à effet de champ

(84) Designated Contracting States:
**AT BE CH DE ES FR GB GR IT LI LU NL SE**

(30) Priority: **04.12.1985 US 805162**

(43) Date of publication of application:
**15.07.1987 Bulletin 1987/29**

(73) Proprietor: **ADVANCED MICRO DEVICES, INC.**
**Sunnyvale, CA 94088-3453 (US)**

(72) Inventors:
• **Liu, Yow-Juang**
**San Jose California 95119 (US)**
• **Cagnina, Salvatore**
**Los Altos California 94022 (US)**

(74) Representative:
**Sanders, Peter Colin Christopher et al**
**BROOKES & MARTIN**
**High Holborn House**
**52/54 High Holborn**
**London WC1V 6SE (GB)**

(56) References cited:
EP-A- 113 540          EP-A- 0 164 449
EP-A- 0 166 167          EP-A- 0 187 260

• **IEEE TRANSACTIONS ON ELECTRON DEVICES,
vol. ED-29, no. 4, April 1982, pages 590-596,
IEEE, New York, US; P.J. TSANG et al.:
"Fabrication of high-performance LDDFET's
with oxide sidewall-spacer technology"**
• **IEEE TRANSACTIONS ON ELECTRON DEVICES,
vol. ED-27, no. 8, August 1980, pages 1359-1367,
IEEE, New York, US; S. OGURA et al.: "Design
and characteristics of the lightly doped
drain-source (LDD) insulated gate field-effect
transistor"**
• **Symposium on VLSI Technology, Koloe, May
14-16, 1985, pp.114, (Tsuashima et al.)**
• **Symposium on VLSI Technology Kobe, May
14-16, 1985, pp.118,119 (Toyoshima et al)**

## Description

The present invention generally relates to field effect transistor (FET) structures and to optimized methods of fabricating both N-and P-channel type FET devices. More specifically, the present invention relates to a transistor geometry that permits operation from relatively large drain to source potential differences in a long channel configuration and at very high speeds in a short channel configuration, both without operational lifetime degradation and, additionally, to the optimized processes of fabricating n-type, p-type and complementary common long and short channel geometry FET transistors in a common monolithic substrate.

In pursuit of improving semiconductor digital logic devices, there is a continual quest to define and produce transistors having ever smaller overall cell geometries and that are capable of operating at ever increasing switching speeds. Cell geometry is here defined as the two-dimensional surface area required for the implementation of a single, integral, active logic element, typically a single N- or P-channel transistor or a pair of complementary transistors. Cell geometry is distinguished from transistor geometry in that the latter refers to the three-dimensional structure of a single, integral active logic element.

Reduced cell geometry is naturally desired to increase cell packing density that, in turn, permits ever increased levels of device integration and corresponding logic system complexity and capability. Increases in operating speed are naturally advantageous regardless of the level of integration realized. Conveniently, these desires are complementary in that a major factor in the operating speed of a field effect transistor is the channel length defined by its transistor geometry. Reduction of channel length results in a corresponding reduction in the time required for charge carriers to transit between the transistor source and drain regions and, to at least a first approximation, the switching speed of the transistor.

There are, however, numerous other complications involved in obtaining high switching speed. small cell geometry transistors. These complications include excessive power dissipation and the onset of short channel effects. Power dissipation is naturally a problem as the sheer number of transistors packed together on a common monolithic substrate increases. Practical construction constraints limit the rate at which power dissipated as heat can be removed from the vicinity of the transistors. A typical manner of dealing with this problem involves reducing the operating potential difference applied to the transistors so as to effect a corresponding decrease in the power dissipated. There is, however, a practical limit to the reduction of the operating potential difference before there is a corresponding degradation of the transistor's operating characteristics, particularly including its switching speed. Again conveniently, this practical limit also tends to decrease as the cell dimensions are reduced.

Short channel effects encountered typically include decreased operating device breakdown voltages, hot carrier effects, punch-through shorting of the transistor and other effects of lesser significance. These short channel effects are generally related to the channel length of the transistor and the electric field strength induced between the source, drain and gate as a result of the applied operating potential difference. Where the electric field is of sufficient strength at the drain/substrate interface, avalanche breakdown will occur leading to the sudden destruction of the transistor. Similarly, if the depletion regions generally associated with the source and drain regions, as induced by the application of the operating potential difference, extend sufficiently toward one another to overlap, then a current punch-through condition will occur wherein the source and drain are effectively shorted together. Again, generally there will be sudden catastrophic destruction of the transistor.

A much less sudden, though equally deleterious short channel effect occurs as the result of the generation of hot carriers near the gate oxide/semiconductor substrate interface. Hot carriers are charge carriers that have been energized by the applied electric field sufficiently to overcome the potential barrier at the oxide/substrate interface. Consequently, the charge carriers are injected directly into the gate oxide where they thereafter remain trapped. As such, the gate operating characteristics of the transistor are progressively degraded from their intended nominal values over the operating lifetime of the transistor.

The short channel effects are also typically handled by reducing the applied operating potential difference so as to reduce the strength of the electrical field established in the transistor. Additionally, the punch-through effect is specifically addressed by generally increasing the doping density within the channel region. This results in an increase in the operating potential difference required to establish overlapping source and drain depletion regions.

The hot carrier effect may be further specifically addressed by providing a very shallow, lightly doped drain (LDD) region at the gate oxide/substrate interface closest to the point within the transistor where the greatest electric field strength occurs. Devices constructed with LDD regions are shown in US-A-4,282,648 and US-A-4,366,613. The provision of such a lightly doped region effectively reduces the electrical field strength adjacent the oxide/substrate interface. Typically, the lightly doped drain region is extremely shallow so as to minimally impact all other electrical characteristics of the drain to channel interface and very lightly doped so as to maximize the corresponding reduction of the electrical field strength within the lightly doped drain region. This reduction in field strength directly reduces the transfer of energy to charge carriers at the oxide/substrate interface with a corresponding reduction in the number of charge carriers injected into the gate oxide. The generation of any hot carriers deeper in the substrate is generally of no concern as they remain in the channel while moving between the source and drain regions. Indeed, it is typically preferred that some hot carriers be generated within the substrate as a tolerable consequence to utilizing an electrical field strength sufficient to move charge carriers between the source and drain regions at an optimally maximum velocity.

In certain applications, reduction of the operating potential difference is not an acceptable solution to dealing with the problems generally described above. Rather, provision must be made for at least some of the transistors present on the common substrate to operate from substantially increased potential differences. Exemplary of these applications are programmable memory devices such as electrically programmable read only memories (EPROM) and floating gate electrically erasable programmable read only memories (EEPROM). In these applications there is a positive desire to greatly increase the packing density of the transistors utilized as memory cells. At the same time, however, there is a positive requirement that a high voltage be tolerated by the transistors as is required whenever their corresponding memory cells are programmed and, where applicable, electrically erased. Typically, current EPROM devices require a programming voltage of between 10 and 20 volts to effect programming. EEPROM devices require programming and erasure voltages typically of between 15 to 25 volts.

Since small cell geometry, high speed transistors are preferably operated at voltages substantially less than 5 volts, typically on the order of 2-4 volts, they cannot be used. Instead, transistors having significantly different deep junction transistor and large cell geometries are typically utilised so that, with their longer channel lengths, the high programming and erasure voltages can be better tolerated. This, however, typically precludes or substantially complicates the use of high speed optimized transistor geometry transistors on the same monolithic memory chip. Thus, the high voltage tolerance is gained at the substantial expense of the total device memory capacity and a substantial reduction in circuit performance. This result is not as desirable as if substantially smaller cell geometry, high speed transistors could be used monolithically with large cell geometry transistors where specifically required for high voltage tolerance.

There have been proposed field effect transistors with a gate structure overly a surface of a substrate to define a channel region, having first and second primary regions in the substrate spaced on either side of the channel region with a first reverse breakdown voltage, and having first and second secondary regions in the substrate, associated respectively with the primary regions and defining the channel region therebetween, with a second reverse breakdown voltage. Examples of such transistors may be found in EP-A-0,166,167 and EP-A-0,164,449, and in the papers "Design and Characteristics of the Lightly Doped Drain-Source (LDD) Insulated Gate Field-Effect Transistor" by Seiki Ogura, et al - IEEE Transactions on Electron Devices, Vol. ED27, No. 8, August 1980. and "Fabrication of High-Performance LDDFET's with Oxide Sidewall-Spacer Technology" by Paul J. Tsang, et al - IEEE Transactions on Electron Devices, Vol. ED-29, No. 4, April 1982.

Further examples of such transistors are disclosed in the papers "Metal-Coated Lightly-Doped Drain (MLD) Mosfets for Sub-Micron VLSI's" by Y. Tsunashima et al and "Profiled Lightly Doped Drain (PLDD) Structure for High Reliable NMOS-FET'S" by Y. Toyoshima et al, 1985 Symposium on VLSI Technology, Digest of Technical Papers, pp 114-115 and 118-119 respectively.

According to one aspect of the present invention there is provided an integrated circuit comprising a plurality of field effect transistors fabricated on a substrate (12) of a semiconductor material of a first conductivity type, said substrate having a major surface, each transistor comprising:

(a) a gate structure overlying said major surface, said gate structure including a gate electrode (38, 38', 40, 40') defining a channel region (34) within said substrate, and a gate oxide layer (46) disposed between said gate electrode and said major surface;
(b) first (18) and second (20) primary regions formed in the substrate and extending from said major surface and respectively spaced apart by an intervening portion of said substrate including said channel region, said primary regions being of a second conductivity type and having a first reverse breakdown voltage corresponding to the relative conductivities of said substrate and said primary regions; and
(c) first (22) and second (24) secondary regions formed in said substrate and extending from said major surface respectively adjacent said first and second primary regions and defining said channel region therebetween, said secondary regions being of like conductivity type as said primary regions and having a second reverse breakdown voltage corresponding to the relative conductivities of said substrate and said secondary regions, said secondary regions respectively having a doping density less than that of said primary regions and said second breakdown voltage being greater than said first breakdown voltage; said first and second secondary regions extending from said major surface to a junction depth substantially the same as that of said first and second primary regions,

characterised in that the doping density of the secondary regions is about one to three orders of magnitude less than that of the primary regions, and at least one of the transistors is operable as a short channel transistor having a first channel length in the range of 0.75 μm - 1.5 μm, and at least one other of the transistors is operable as a long channel transistor having a second channel length greater than the first channel length and being in the range of 1.5 - 3.0 µm, the doping density in the secondary regions of the long channel transistors being lower than the doping density in the secondary regions of the short channel transistors.

According to a further aspect of the invention there is provided a method of fabricating such an integrated circuit, the method comprising:

forming gate structures overlying the major surface of the substrate, each gate structure including a gate electrode defining a channel region within said substrate and a gate oxide layer disposed between said gate electrode and said major surface;

implanting a first dopant of the second conductivity type to form lightly doped secondary regions for each transistor, the lightly doped regions extending from the major surface to a predetermined depth between 0.2 and 0.8µm and being respectively spaced apart by an intervening portion of said substrate including said channel region, the lightly doped regions being aligned with respect to the edges of the respective gate structures and having a first reverse breakdown voltage corresponding to the conductivity of said regions relative to that of said substrate;

forming a border mask bordering and extending beyond the edges of the gate structure so as to mask respective portions of said lightly doped secondary regions, and

implanting a second dopant in the unmasked portions of said lightly doped secondary regions to form more heavily doped primary regions within the substrate co-extensive with respective portions of the said lightly doped secondary regions, the primary regions being spaced apart from one another and aligned with respective edges of said border mask and respectively extending below said major surface to about said predetermined depth,

the respective doping densities of the lightly doped secondary regions and the channel region being such that at least one of the transistors is a short channel transistor having a first channel length in the range of 0.75 µm - 1.5 µm and at least one other of the transistors is a long channel transistor having a second channel length greater than the first channel length and being in the range of 1.5 µm - 3.0 µm, an increased doping density being obtained in the secondary regions of the short channel transistors by masking the long channel transistor regions while implanting dopant of the second conductivity type in the secondary regions of the short channel transistor regions prior to implanting the said first dopant.

Accordingly, there is provided an integrated circuit having both high speed, small cell and high voltage tolerant long channel field effect transistors fabricated in a common monolithic substrate. The short and long channel transistors can be simultaneously fabricated on the substrate with minimal additional processing required.

In the accompanying drawings, by way of example only:

Fig. 1 provides a cross-sectional view of an EEPROM memory cell;
Fig. 2 provides a cross-sectional view of a transistor for illustrating the low voltage operation thereof;
Fig. 3 provides a cross-sectional view of the transistor of Fig. 2 illustrating the high voltage operation thereof;
Figs. 4-9 provide cross-sectional views of preferred complementary metal oxide semiconductor transistor cells illustrating the successive steps in a preferred mode of their fabrication; and
Fig. 10 provides a cross-sectional view of preferred complementary metal oxide semiconductor transistor cells.

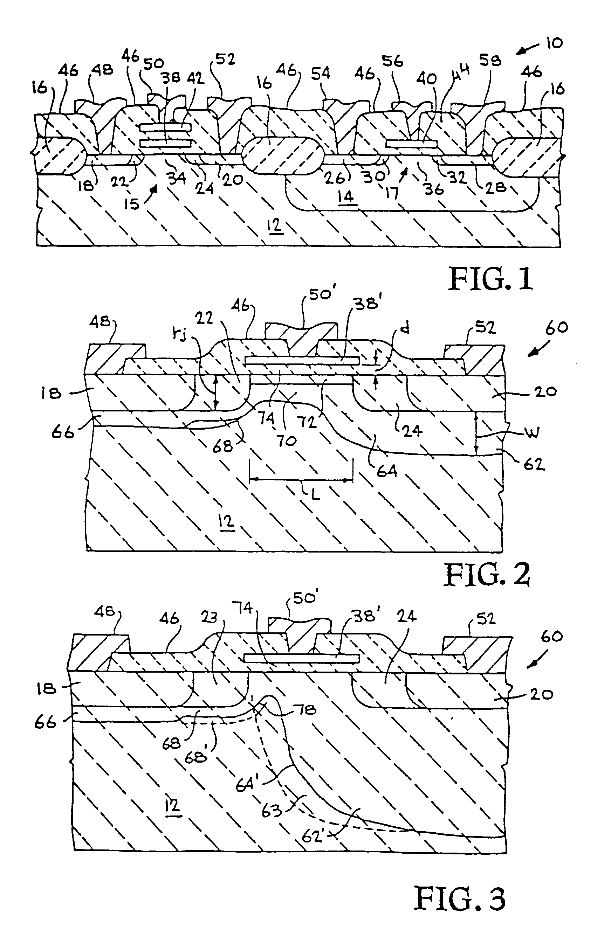

The pertinent aspects of the transistor geometry characteristic are exemplified in an EEPROM device. with an associated complementary channel type FET device, both generally indicated by the reference numeral 10, as shown in Fig. 1. For purposes of clarity, an EEPROM gate contact structure is only generally shown in Fig. 1. The preferred EEPROM gate structure and the preferred manner of its fabrication are disclosed in our copending European application 86304038.2. The above disclosure of the EEPROM gate electrode structure is expressly incorporated herein by reference. The present invention, however, is not to be construed narrowly as being limited only to use in EEPROM devices. The present invention is capable of much wider application. In particular, the present invention is suitable for use in all applications wherein the use of a small cell geometry, high switching speed and high operating voltage tolerant transistors are desirable.

Considering now the exemplary EEPROM transistor geometry 10 of Fig. 1, a substrate 12, preferably of silicon, having a nominal body doping density of approximately $8 \times 10^{14}$ cm$^{-3}$ of a p-type impurity such as boron is shown. A well region 14 is provided within the substrate 12 and adjacent a portion of the surface thereof. The well region 14 is preferably doped n-type by the provision of an impurity such as phosphorus to a doping density of approximately $8 \times 10^{15}$ cm$^{-3}$. Field oxide portions 16 are preferably provided at the perimeter of the well region 14 and other surface portion areas so as to define surface area regions 15, 17 for the discrete fabrication of respective N- and P-channel transistors.

Highly doped n-type source and drain regions 18, 20 are provided at the semiconductor surface within a N-channel transistor areas. The doping level of the source and drain regions is preferably above $1\times10^{20}$ cm$^{-3}$ utilizing, for example, an arsenic impurity. Source and drain extension regions 22, 24, preferably doped with a phosphorus impurity, to a level of about $5\times10^{17}$ cm$^{-3}$, are respectively provided so as to electrically extend the source and drain regions 18, 20 toward one another and define a channel region 34 having a length of about 0.75 to 3.0 micrometers. EEPROM gate electrodes 38, 42 are provided in a layer of oxide 46 so as to overlay the channel region 34. Consistent with EEPROM gate structures, a gate contact 50 is provided to the uppermost gate electrode 42 while leaving the lower gate electrode 38 essentially electrically isolated within the oxide 46. The N-channel EEPROM transistor is substantially completed with the provision of source and drain contacts 48, 52 to the source and drain regions 18, 20, respectively.

Similarly, for the P-channel transistor highly doped p-type source and drain regions 26, 28 are provided in the N-well 14 at the surface area 17 of the semiconductor substrate 12. The source and drain regions 26. 28 are preferably provided at a doping density of $5\times10^{19}$ cm$^{-3}$, primarily through the implantation of BF$_2$ impurities. Source and drain extension regions 30, 32 are respectively provided adjacent the source and drain regions 26. 28 and positioned so as to define the channel 36 with a channel length of about 0.75 to 3.0 micrometers. These extension regions 30, 32 are preferably provided with a doping density of $1\times10^{18}$ cm$^{-3}$ utilizing a boron impurity.

The MOSFET gate structure for a P-channel transistor is completed with the provision of the isolated and control gate 40 suspended in the oxide layer 46 so as to overlay the channel region 36. Finally, the source 54, gate 56, and drain contact 58 provide conduction paths to the source region 26, control gate 40, and drain region 28.

Referring now to Fig. 2, an operating state of a transistor is illustrated. The gate structure shown is simplified to that of a conventional FET device so as not to obscure the pertinent aspects of the present invention. Further, only the operation of an N-channel device 60 will be described as the operation of a P-channel device is directly analogous. Considering Fig. 2 in greater detail, the preferred transistor geometry employs source and drain extension regions 22, 24 having junction depths rj that closely match the junction depths of the source and drain regions 18, 20. With the application of an operating potential difference between the source and drain contacts 48, 52, referenced positive with respect to the drain 20, and by the application as a small positive voltage potential to the gate contact 50', and therefore to the gate electrode 38', source, source extension, channel, drain extension and drain depletion regions 66, 68, 70, 64 and 62 are formed. Excepting that the source and drain extension regions 22, 24 of the device 60 have a doping density significantly less than that of the source and drain regions 18, 20, the dimensions of the FET device 60, when selected for high speed operation, are preferably such that it would conventionally be classified as a short-channel device and, alternately, when selected for high voltage operation, as a long channel device. The conventionally accepted, though empirical, short channel transistor definition establishes a dividing line based on the minimum channel length L for which long channel operating characteristics can be still observed. In the device 60, the channel length L is measured between the closest respectively approaching edges of the source and drain extension regions 22, 24. The minimum channel length $L_{min}$ for a desired transistor geometry that exhibits long channel characteristics may be determined from empirical equation 1:

$$L_{min} = 0.4 \, [r_j d(W_s + W_d)^2]^{1/3} \, , \qquad\qquad \text{Eq.1}$$

where $r_j$ is the junction depth of the source and drain regions 18, 20 in micrometers, d is the thickness of the gate oxide 74 in angstroms, $W_s$ is the depletion region width 66 associated with the source region 18 and $W_d$ is the depletion region width 62 associated with the drain region 20, both in micrometers. Sze, Physics of Semiconductors, (1981) at pg.77. The depletion region widths $W_s$ and $W_d$ are readily determined from equations 2 and 3:

$$W_d = \sqrt{\frac{2\varepsilon_s}{qN_A} (V_{bi} + V_{BS})} \, , \text{ for } N_D \gg N_A \qquad\qquad \text{Eq. 2}$$

$$W_s = \sqrt{\frac{2\varepsilon_s}{qN_A} (V_D + V_{bi} + V_{BS})} \, , \text{ for } N_D \gg N_A \qquad\qquad \text{Eq. 3}$$

where $V_{bi}$ is the built-in voltage of the junction, $V_{BS}$ is the substrate bias, $\varepsilon_s$ is the semiconductor substrate permutivity and $N_A$ is the impurity density of the substrate 12.

In the device 60, the doping densities of the source and drain extension regions 22, 24 are preferably reduced by one to three orders of magnitude with respect to the source and drain regions 18, 20. As is illustrated in Fig. 2, the depletion regions 68, 64 associated with the source and drain extension regions 22, 24 are therefore somewhat decreased with respect to the depletion region 66, 62. The doping density within the extension regions 22, 24 may be sufficiently reduced such that the abrupt junction assumption for calculating depletion widths is may be no longer accurate. Accordingly, the widths of the depletion regions 68, 64 may be correctly calculated using equations 4 and 5:

$$W_s = \sqrt{\frac{2\varepsilon_s}{q}\left(\frac{N_A + N_D}{N_A\ N_D}\right)\ (V_{bi} + V_{BS})} \quad, \qquad Eq.\ 4$$

$$W_d = \sqrt{\frac{2\varepsilon_s}{q}\left(\frac{N_A + N_D}{N_A\ N_D}\right)\ (V_{bi} + V_{BS} + V_D)} \quad, \qquad Eq.\ 5$$

where $N_D$ is the donor impurity concentration of the source and drain extension regions 22, 24.

An immediate, though slight, benefit evidenced by the device 60 is that the effective channel length $L_{eff}$ of the FET device 60, in short channel embodiments, varies to a slight but distinctly lesser degree with changes in the operating potential difference as compared to conventional short channel devices, particularly in the presence of a relatively high short channel operating potential. In conventional FET devices, the effective channel length is defined as:

$$L_{eff} = L - y_s - y_d \qquad\qquad Eq.\ 6$$

where L, is the fabricated channel length, $y_s$ is the horizontal depletion region width associated with the source and $y_d$ is the horizontal depletion region width associated with the drain. The horizontal depletion widths are given by:

$$y_s = \sqrt{\frac{2\varepsilon_s}{q}\left(\frac{N_A + N_D}{N_A\ N_D}\right)\ (V_{bi} - \psi_s - V_{BS})} \quad, \qquad Eq.\ 7$$

$$y_d = \sqrt{\frac{2\varepsilon_s}{q}\left(\frac{N_A + N_D}{N_A\ N_D}\right)\ (V_{bi} + \psi_s + V_{BS} + V_D)} \quad, \quad Eq.\ 8$$

where $\psi_s$ is the channel substrate surface potential. As can be seen by comparison of equations 4-5 and 7-8, the horizontal depletion regions $y_s$, $y_d$ are slightly less than the depletion regions widths $W_s$ and $W_d$ and, accordingly, will vary slightly less for equivalent changes in operating potential.

Depending on the voltage potential applied to the gate contact 50', a channel region 72 may be induced, permitting controlled conduction between the source and drain regions 18, 20 via the source and drain extension regions 22, 24. Any added channel resistance incurred as a result of the channel extension regions, 22, 24 may be reduced by increasing the doping density of the extension regions 22, 24 and by reducing their width in line with the channel 72 between the source and drain regions 18, 20. Alternately, the source extension region 22 can be completely omitted to further reduce channel resistance.

Operation of the FET device 60 at high operating potential differences, relative to respective short and long channel embodiments of the device, is illustrated in Fig. 3. Excepting again that the source and drain extension regions 22, 24 of the device 60 are of a lesser doping density with respect to the source and drain regions 18, 20, the increased operating potential difference results in a substantially increased depletion region width. Above a critical operating potential difference, a conventional drain depletion region 63 would overlap in an area 78 with a depletion region 68' associated with a conventional source region. This circumstance is known as punch-through and is defined as occurring when the effective channel length $L_{eff}$ is reduced to zero. The critical punch-through voltage for a particular transistor geometry $V_{Dpt}$ can be determined from equations 6, 7 and 8 for a given channel length L.

In the device 60, the source and drain extension regions 22, 24 are not of the same doping density as the source and drain regions 18, 20. Instead, they are of significantly lesser doping density (again, preferably, one to three orders of magnitude less) and, by virtue of their respective placement relative to the source and drain regions 18 and 20 so as to exclusively define the channel region 34, their doping density directly influences the horizontal extent of the source and drain depletion regions $y_s$, $y_d$. As can be seen from equations 7 and 8, reduction in the donor impurity doping density directly reduces both $y_s$ and $y_d$. Reduction of the doping density, particularly that of the drain extension region 24, results in the slightly reduced width of depletion region 64' as shown in Fig. 3. Similarly, there is as reduction in the depletion region width of the depletion region 68 associated with the source extension region 22, though to an even relatively lesser degree.

For long channel embodiments of the device 60, the reduction in horizontal depletion region widths is generally negligible relative to the length of the channel. Thus the punch-through potential difference limit is established by the doping density established by a deep channel implant for any particular channel length. This implant density is, in turn, limited by a phenomenon conventionally known as body effect. This phenomenon is dependent on both the doping density and volume of the channel region. The consequence of body effect is an increase in the time required to clear the channel region of charge carriers, either by recombination or drift into the substrate bulk. Thus, for channel lengths of 1.5 to 3.0 micrometers, an upper limit of approximately $1 \times 10^{15}$ cm$^{-3}$ in the channel region is preferred.

Short channel embodiments of the device 60 benefit greatly from a reduced sensitivity to body effect. The lower volume of the channel region allows a corresponding increase in the channel doping density. Thus, for channel lengths of about .75 to 1.5 micrometers, an upper limit of $1 \times 10^{16}$ cm$^{-3}$ in the channel region is preferred. Additionally, the effect of the presence of the source and drain extension regions is proportionally greater than to that in long channel embodiments, though still slight with respect to the effect of the increased allowable channel doping density.

Operation at high operating potential differences, however, requires more than precluding the occurrence of punch-through. High voltage operation also requires that the FET device 60 be tolerant of the maximum operating voltage corresponding electric fields created within the device 60. The drain substrate junction of convention FET devices is the most sensitive to electric field strength. The critical junction breakdown voltage $V_{bd}$, corresponding to the maximum electric field strength that maybe tolerably induced by the applied operating potential voltage, is given by equation 9:

$$V_{bd} = \frac{\varepsilon_s \, \xi_m^2}{2q} \left( \frac{1}{N_A} + \frac{1}{N_D} \right) \qquad Eq. \ 9$$

where $V_{bd}$ is equal to the drain voltage potential relative to the gate and source voltage potentials.

In accordance with the present invention, it is recognized that the peak electric field strength is substantially localized to that portion of the drain/substrate junction closest to the gate, particularly when the gate is maintained at the source voltage potential i.e., gated diode configuration. By virtue of the drain extension region 24, as provided in the device 60, a significant reduction in the maximum electric field $\xi_m$ is obtained within the drain extension region near the extension/substrate junction closest to the gate electrode 38'. Calculation of the electric field strength induced by the juxtaposition of the drain extension region 24 and, th gate electrode 38' is largely empirical. However, the increase in breakdown voltage obtainable in the device 60 may be directly extrapolated from the performance characteristics of conventional, well characterized FET devices, by specifically taking into account the reduced doping density of the drain extension region 24.

Consequently, both long and short channel embodiment of the FET device 60, in accordance with the present invention, can be operated from distinctly greater respective potential differences than generally corresponding conventional FET devices before reaching the onset limit of the punch-through or gated diode breakdown conditions. This is accomplished while retaining, in short channel embodiments. the high speed capabilities and substantially the same ease of fabrication of conventional short channel transistors and, further, while allowing the simultaneous fabrication of essentially identical transistor geometry, high voltage tolerant long channel devices on the same monolithic substrate.

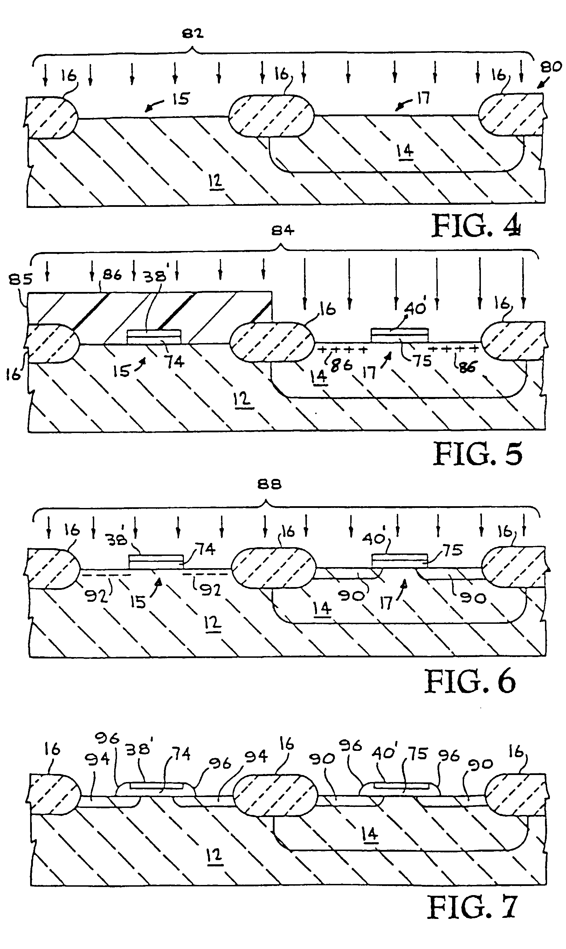

Considering now Fig. 4, there is shown the initial stage of the fabrication of a preferred, complementary FET transistor geometry. The initial substrate structure 80 preferably is composed of the substrate 12 having a background doping density generally in the range of $1 \times 10^{14}$ cm$^{-3}$ to $5 \times 10^{15}$ cm$^{-3}$ and preferably in the range or $5 \times 10^{-14}$ cm$^{-3}$ to $1 \times 10^{15}$ cm$^{-3}$ by the presence of p-type impurities such as boron. An N-well 14 is preferably provided at a surface of the substrate 12 by conventional fabrication procedures. The doping density of the N-well 14 is generally in the range of $1 \times 10^{15}$ cm$^{-3}$ to $1 \times 10^{17}$ cm$^{-3}$ and preferably in the range of $5 \times 10^{15}$ cm$^{-3}$ to $1 \times 10^{16}$ cm$^{-3}$ by the provision of n-type impurities, such as phosphorus. An N-channel transistor area 15 and P-channel transistor area 17 are delimited by portions of a field oxide 16 fabricated utilizing a conventional nitride mask, local silicon oxidation procedure and then left exposed by the stripping of the nitride masks.

Two ion implantations, preferably of p-type impurities, are then performed to provide the punch-through doping and to adjust the threshold voltages of both the N and P-channel transistors. The first implant is preferably the punch-

7

through implant. It is generally performed at an implant energy ranging from 50 to 150 KeV, and preferably at about 110 KeV, utilizing boron impurity ions. The energy of the implant is selected so as to generally match the junction depth of the source and drain regions that are to be fabricated. The dosage of the implant is selected to optimize the resistance to punch-through conditions for high speed, short channel or high voltage, long channel operation of the eventual N-channel transistor. Preferably, this punch-through implant is provided to a dosage of between $5x10^{10}$ cm$^{-2}$ and $5x10^{11}$ cm$^{-2}$ for long channel devices and between $1x10^{11}$ cm$^{-2}$ and $1x10^{12}$ cm$^{-2}$ for short channel device depending on the actual channel length of the device. Where according to the present invention both long and short channel transistors are to be fabricated on a common substrate, the punch-through implant is first performed to the extent appropriate for the long channel devices. A mask is then provided covering the long channel devices and the punch-through implant continued as appropriate and desired for the exposed short channel devices. Significantly, this fabrication difference is the only one required in accordance with the present invention to provide for co-resident high speed, high density FETs and high voltage tolerant FETs.

The second ion implantation is performed at a low implant energy, preferably of between 20 and 40 KeV, so as to place p-type impurities just beneath the surface of the substrate in the N and P-channel transistor areas 15, 17. The dosage of this second ion implant is chosen to substantially define the threshold voltage of both of the eventual transistors, preferably at about 0.6 volts. Accordingly, boron impurities are preferably provided to a dosage of between $1x10^{11}$ cm$^{-2}$ and $1x10^{12}$ cm$^{-2}$, depending on the particular desired threshold voltage.

As may be observed from Fig. 5, conventional processing steps are then performed to provide gate oxide layers 74, 75 and gates 38', 40' respectively overlying the N and P-channel transistor areas 15, 17. Preferably the gate oxide layers 74, 75 are silicon dioxide having a thickness ranging between 150 and 500 angstroms (10 angstroms (Å) = 1μm). The thickness of gate oxide for each type of transistor (N or P) may be separately optimized in a conventional manner. The gates 38', 40' are preferably polycrystalline silicon having a thicknesses of about 5,500 angstroms.

A resist mask 85 is then provided over the N-channel transistor area 15. An ion implantation of p-type impurities 84 is then performed. The energy of the implant is limited so that, by the presence of the resist mask 85, gate/oxide structure 40', 75 and the exposed portions of the field oxide 16, the p-type impurities 84 are only implanted into the well region 14 through the exposed surface area of the P-channel transistor area 17. The resulting distributions or p-type implanted ions 86 are closely aligned with the edges of the gate/oxide structure 40', 75 and the edges of the field oxide 16. The implant, however, must be of sufficient energy to provide for the desired eventual junction depths of, preferably, between 0.2 and 0.8 micrometers. Generally, this ion implantation is performed at an energy within the range of 10 to 50 KeV to provide p-type impurities to a dosage of $5x10^{13}$ cm$^{-2}$ to $1x10^{15}$ cm$^{-2}$ and preferably at an energy within the range of 20 to 40 KeV, providing boron ions to a dosage ranging from $1x10^{14}$ cm$^{-2}$ to $5x10^{14}$ cm$^{-2}$ for an eventual junction depth of between 0.3 and 0.5 micrometers. Following the ion implantation, the resist mask 85 is striped away and a short annealing of the substrate structure 80 is performed to lightly drive in and anneal the implanted ions 86 to form the initial regions 90.

As indicated in Fig. 6, a blanket ion implant of n-type impurities 88 is then preferably performed. The implanted ions 88 are provided to provide a dosage preferably about one order of magnitude less than that of the annealed p-type regions 90. Thus, an additional masking step to block this counter doping is obviated. As before, the gate/oxide structures 38'. 74, 40', 75 and the field oxide region 16 prevent the implantation of the ions 88 thereunder. That is, the ions implanted into the regions 90 act as only a light counter doping that do not significantly change their net impurity concentration. These ions are also implanted through the exposed surface area of the N-channel transistor surface 15 to form the implanted distributions 92 in alignment with the respective edges of the gateioxide structure 38', 74 and the field oxide 16. Generally, the n-type impurities 88 are implanted at an energy within the range of 20 to 100 KeV, preferably to match the junction depth of regions 90, to a dosage of between $5x10^{12}$ cm$^{-2}$ to $1x10^{14}$ cm$^{-2}$ and, preferably, phosphorous ions are implanted at an energy of between 30 and 80 KeV to provide a dosage of about $1x10^{13}$ cm$^{-2}$ to $5x10^{13}$ cm$^{-2}$.

Next an oxide layer is provided over the surface of the substrate 12 to a thickness sufficient at least to cover the gate electrodes 38', 40'. Preferably, this oxide layer is provided by a conventional liquid phase chemical vapor deposition (LPCVD) of silicon dioxide to a thickness ranging between 4000 and 8000Å and preferably of about 6000Å. A reactive ion etching of the LPCVD oxide layer is then performed to remove most of the oxide layer. As shown in Fig. 7, oxide sidewall spacers 96, present adjacent the gate/oxide structures 38', 74 and 40', 75 remain while essentially all of the LPCVD oxide layer has been removed from the top of the gate electrodes 38', 40'. Also exposed are portions of the substrate surface overlying the ion implanted regions 90, 94; the latter regions 94 having been annealed substantially as the result of the thermal cycling through the oxide layer deposition and reactive ion etching steps. Significantly, in accordance with the present invention, the oxide sidewall spacers 96 extend over corresponding portions of the implanted regions 90, 94. The lateral extent of the oxide sidewall spacers 96 is generally dependent on the thickness of the gate/oxide structures 38', 74 and 40', 75 and the etch rate of the reactive ion etching. The reactive ion etching may be performed at oxide removal rates ranging between 300Å and 600Å per minute and preferably at a rate of between about 400Å and 500Å per minute. For the preferred ranges of gate electrode 38', 40' and gate oxide 74, 75 thicknesses, the oxide sidewall spacers preferably range between 0.3 and 0.7 micrometers, as measured between the edges of the gate electrodes 38', 40' and the nearest exposed edges of their respective N and P-channel transistor surface areas.

Following the reactive ion etching, an annealing and thin oxide growth step is then performed. The annealing and oxide growth step is performed at a low temperature, preferably in the range of 700 to 950 degrees centigrade, and in a dry oxygen ambient, so as to provide the thin oxide layer in a thickness range of 100 to 200Å over the entire surface of the substrate 12. As a consequence of the annealing, the implanted ion distributions 92 are stablized within the substrate to form the lightly doped regions 94. The thin oxide layer itself is provided generally to protect the surface of substrate 12 from undesirable contamination during the subsequent processing steps. The thickness of the oxide layer, however, is insufficient to significantly effect the intended results of the subsequent fabrication steps.

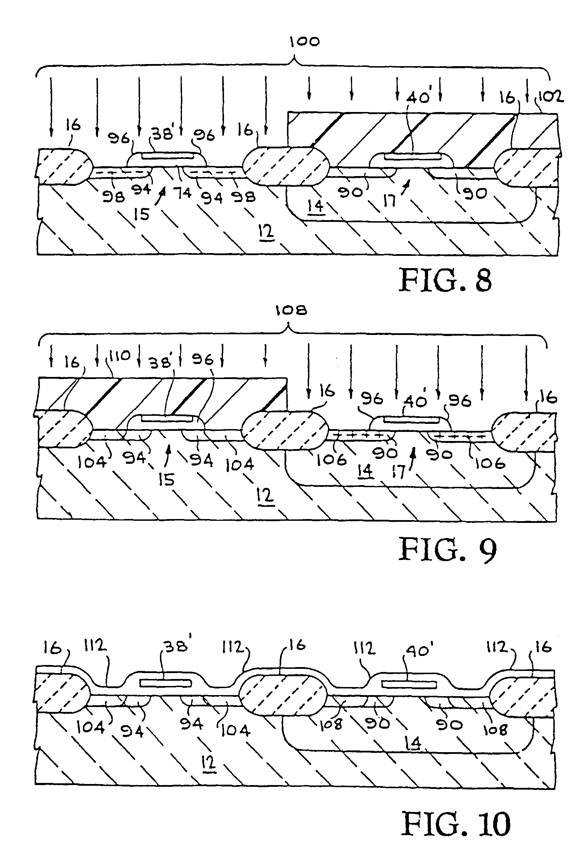

A second resist mask 102 is then provided, as shown in Fig. 8, so as to cover the P-channel surface area 17. An ion implantation of n-type impurities 100 is then performed. By the presence of the resist mask 102, portions of the field oxide 16, the gate/oxide structure 38', 74 and the sidewall spacers 96, the n-type impurities 100 are implanted into a subportion of the n-type impurity region 94. Preferably, the implanted ions 98 are implanted at energies ranging between 25 and 50 KeV and at dosages ranging between $1 \times 10^{15}$ cm$^{-2}$ and $1 \times 10^{16}$ cm$^{-2}$ so as to provide process final conductivities generally corresponding with conventional source and drain regions.

The resist mask 102 is then stripped from the substrate 12 and an N-channel source and drain annealing cycle is performed. Consequently, source and drain regions 104 are formed in intimate contact with the remaining portions of the lighter doped regions 94. The implant energy is chosen to have distributed the impurities 98 at depths that will yield source and drain region 104 junction depths substantially the same as the junction depths of the source and drain extension regions 94.

As shown in Fig. 9, the N-channel transistor area 15 is next covered by a resist mask 110 and another ion implantation is performed. The ions 108 are implanted through the essentially exposed surface area of the P-channel transistor area 17, as defined by the field oxide sections 16 and oxide sidewall spacers 96 adjacent the gate electrode 40'. Thus, the implanted ion distributions 106 are provided only in respective subportions of the source and drain lightly doped regions 90. As before, the implanted ion distribution 106 are substantially aligned with the edges of the oxide sidewall spacers 96.

The p-type ions 108 are generally provided at energies ranging between 10 and 60 KeV and, preferably, BF$_2$ ions 108 are implanted at an energy within the range of about 25 to 50 KeV to a dosage of between about $1 \times 10^{15}$ and $1 \times 10^{16}$ cm$^{-2}$. The choice of BF2 ions is preferred as readily providing the desired p-type impurities to a sufficient concentration generally matching that of conventional source and drain regions with junction depths appropriately shallow as to match the junction depth of the regions 90. The implanted ion distributions 106 are then annealed to form the final source and drain regions 108. The desired usage of a low temperature, short duration anneal for the source and drain regions 108 is to minimize any further diffusion the other implanted regions.

Finally, as shown in Fig. 10, a further oxide layer 112 may be provided over the surface of the substrate 12 as its initial oxide passivation layer. Additionally the layer 112 may serve as the oxide layer separating the control and isolated gate electrodes of an EEPROM device and to form the isolating layer for the first interconnecting metalization layer. The choice and utilization of such further processing steps are independent of the practice of the present invention.

Examples

Example 1: Short Channel, High Speed

An FET transistor was fabricated in a p-type silicon substrate having a background doping density of about $8 \times 10^{14}$ cm$^{-3}$ of a boron impurity. The P-channel transistor N-well region was formed to a depth of 3.5 micrometers beneath the substrate surface of the eventual channel region thereof. The well region was doped to a density of approximately $8 \times 10^{15}$ cm$^{-2}$ using a phosphorus impurity. Nitride masks were placed to define the active transistor regions, followed by a field oxide growth to a thickness of about 1300Å. After removal of the nitride, the punch-through and threshold adjusting ion implants were performed at energies of 110 and 32 KeV and dosages of $1 \times 10^{12}$ and $5 \times 10^{11}$ cm$^{-2}$, respectively both using boron impurities. A gate oxide layer was then grown to a thickness of about 300Å. A polysilicon layer was deposited, masked and etched to form a gate electrode having a length of 1.5 micrometers and thickness of 5500Å. The corresponding length of the gate oxide layer was simultaneously defined. Lightly doped source and drain regions were then formed having junction depths of 0.4 micrometers by implantation of boron at 30 KeV and at a dosage of $2 \times 10^{14}$ cm$^{-2}$. This was followed by an anneal step of 900°C for 30 minutes. The implantation of the lightly doped N-channel source and drain regions was then performed at an implant energy of 60 KeV providing a dosage of $3 \times 10^{13}$ cm$^{-2}$ using a phosphorus impurity. This resulted in lightly doped source and drain regions having a junction depth of 0.3 micrometers. As a result of the sequential oxide deposition, to a thickness of 6000Å. and reactive ion etching steps next performed, silicon dioxide sidewall spacers were formed having a lateral extent of 0.5 micrometers beyond the respective edges of the gate electrodes. The P-channel source and drain implant was then performed at an energy of 50 KeV to a dosage of $7x10^{15}$ $cm^{-2}$ to provide n-type source and drain regions having junction depths closely matching that of the lightly doped n-type regions, but having a much higher doping density of as established after a drive-in at a temperature of 900°C for a period of 2 hours, followed by a 10 wet ambient minute oxidation at 900°C. The p-type source and drain regions were implanted at an energy of 60 KeV at a dosage of $7x10^{15}$ $cm^{-2}$ to again provide source and drain regions having junction depths closely matching that of the lightly doped p-type source and drain regions but having a much higher doping density. The final anneal was performed at a temperature of 900°C for a period of 50 minutes.

The resulting transistor geometry yielded devices having a channel length of 1.5 micrometers. Operating potential differences of 13 volts VDs were readily supported without the onset of punch-through, gated diode breakdown or significant oxide charging. Further, the device exhibited standard gate switching characteristics including a switching delay estimated at about 280 pico seconds. Testing of the device indicated that about one order of magnitude less hot electrons were being generated than typical in comparable, conventional devices and, therefore, not being injected into the gate oxide. Further, the device exhibited no significant change in body factor over comparable conventional devices.

Example 2: <u>Short Channel High Speed</u>

Another transistor was fabricated having a channel length of 1.25 micrometers. In all other significant aspects, the fabrication procedure was the same as used in Example 1. Operation at a potential difference of 7 volts $V_{DS}$ was readily supported without the onset of punch-through gated diode breakdown or significant gated oxide charging.

Example 3: <u>Long Channel High Voltage</u>

Another transistor was fabricated having a channel length of 2.0 micrometers. At this channel length, the punch-through implant was performed only to a dosage of $2x10^{11}$ $cm^{-2}$; the additional channel length contributing to the resistance of punch-through. In all other significant aspects, the fabrication procedure was the same as used in Example 1. Operation at a potential difference of 15 volts $V_{DS}$ was readily supported without the onset of punch-through, junction breakdown or significant gate oxide charging.

Example 4: <u>Long Channel High Voltage</u>

Another transistor was fabricated having a channel length of 2.5 micrometers. In all other significant aspects, the fabrication procedure was the same as used in Example 3. Operation at a potential difference of 21 volts $V_{DS}$ was readily supported without the onset of punch-through, gated diode breakdown or significant gate oxide charging.

Thus, both a high speed, small cell geometry FET and a long channel FET sharing a common transistor geometry capable of operating from respective, relatively high operating potential differences, and an optimal process for their fabrication, have been described.

Clearly, many modifications and variations of the present invention are possible and contemplated in light or the above teachings. These modifications may include changes in the specific conductivity type of the substrate and regions formed therein, the specific impurities used, the impurity concentrations and the manner of their provision, and the processing times and temperatures employed throughout. Further, the specific details of conventional oxide growth, lithographic masking, oxide etching and removal steps have not been described in order not to obscure the present invention. It is therefore to be understood that, within the scope of the appended claims, the invention may be practiced otherwise than as specifically described above.

**Claims**

1. An integrated circuit comprising a plurality of field effect transistors fabricated on a substrate (12) of a semiconductor material of a first conductivity type, said substrate having a major surface, each transistor comprising:

   (a) a gate structure overlying said major surface, said gate structure including a gate electrode (38, 38', 40, 40') defining a channel region (34) within said substrate, and a gate oxide layer (46) disposed between said gate electrode and said major surface;

   (b) first (18) and second (20) primary regions formed in the substrate and extending from said major surface and respectively spaced apart by an intervening portion of said substrate including said channel region, said primary regions being of a second conductivity type and having a first reverse breakdown voltage corresponding to the relative conductivities of said substrate and said primary regions; and

(c) first (22) and second (24) secondary regions formed in said substrate and extending from said major surface respectively adjacent said first and second primary regions and defining said channel region therebetween, said secondary regions being of like conductivity type as said primary regions and having a second reverse breakdown voltage corresponding to the relative conductivities of said substrate and said secondary regions, said secondary regions respectively having a doping density less than that of said primary regions and said second breakdown voltage being greater than said first breakdown voltage; said first and second secondary regions extending from said major surface to a junction depth substantially the same as that of said first and second primary regions,

characterised in that the respective doping densities of said secondary regions and said channel region are such that at least one of the transistors is a short channel transistor having a first channel length in the range of 0.75 µm - 1.5 µm, and at least one other of the transistors is a long channel transistor having a second channel length greater than the first channel length and being in the range of 1.5 - 3.0 µm, the doping density in the secondary regions of the long channel transistors being lower than the doping density in the secondary regions of the short channel transistors.

2. An integrated circuit according to claim 1 wherein the doping density of the secondary regions is about one to three orders of magnitude less than that of the primary regions.

3. An integrated circuit according to claim 1 or claim 2 characterised in that said gate oxide layer has a thickness of less than 50 nm.

4. An integrated circuit according to claim 3, characterised in that said gate oxide layer has a thickness of less than 30 nm.

5. A method of fabricating an integrated circuit according to any one of the preceding claims, the method comprising forming gate structures overlying the major surface of the substrate, each gate structure including a gate electrode (38, 38', 40, 40') defining a channel region (34, 36) within said substrate and a gate oxide layer (46) disposed between said gate electrode and said major surface;

implanting a first dopant (84, 88) of the second conductivity type to form lightly doped secondary regions (90, 94) for each transistor, the lightly doped regions extending from the major surface to a predetermined depth between 0.2 and 0.8µm and being respectively spaced apart by an intervening portion of said substrate (12) including said channel region (34, 36), the lightly doped regions being aligned with respect to the edges of the respective gate structures and having a first reverse breakdown voltage corresponding to the conductivity of said regions relative to that of said substrate;
forming a border mask (96) bordering and extending beyond the edges of the gate structure so as to mask respective portions of said lightly doped secondary regions (90, 94), and
implanting a second dopant (100, 108) in the unmasked portions of said lightly doped secondary regions to form more heavily doped primary regions (108, 104) within the substrate (12) co-extensive with respective portions of the said lightly doped secondary regions (90, 94), the primary regions (108, 104) being spaced apart from one another and aligned with respective edges of said border mask (96) and respectively extending below said major surface to about said predetermined depth;
the respective doping densities of the lightly doped secondary regions (90, 94) and the channel region being such that at least one of the transistors is a short channel transistor having a first channel length in the range of 0.75 µm - 1.5 µm and at least one other of the transistors is a long channel transistor having a second channel length greater than the first channel length and being in the range of 1.5 µm - 3.0 µm, an increased doping density being obtained in the secondary regions of the short channel transistors by masking the long channel transistor regions while implanting dopant of the second conductivity type in the secondary regions of the short channel transistor regions prior to implanting the said first dopant.

6. The method of claim 5, characterised in that said border mask overlying said lightly doped secondary regions extends beyond the edges of said gate mask for an extent in the range of about 0.25 to 0.75 micrometers.

7. A method according to claim 5 or claim 6 characterised in that said substrate has a background P-conductivity type doping density of about $8 \times 10^{14}$ cm$^{-3}$ or an N-conductivity type doping density of about $8 \times 10^{15}$ cm$^{-3}$.

**Patentansprüche**

1. Integrierte Schaltung mit mehreren Feldeffekttransistoren, die auf einem Substrat (12) aus einem Halbleitermaterial eines ersten Leitfähigkeitstyps ausgebildet ist, wobei das Substrat eine Hauptfläche aufweist, und wobei jeder Transistor aufweist:

   (a) eine die Hauptfläche überlagernde Gatestruktur, die eine Gateelektrode (38, 38', 40, 40'), welche einen Kanalbereich (34) in dem Substrat bildet, und eine zwischen der Gateelektrode und der Hauptfläche angeordnete Gate-Oxidschicht (46) aufweist;

   (b) einen ersten (18) und einem zweiten (20) Primärbereich, die in dem Substrat ausgebildet sind und sich von der Hauptfläche aus erstrecken und durch einen den Kanalbereich enthaltenden dazwischen liegenden Bereich des Substrats voneinander getrennt sind, wobei die Primärbereiche von einem zweiten Leitfähigkeitstyp sind und eine erste Umkehr-Durchbruchsspannung aufweisen, die den jeweiligen Leitfähigkeiten des Substrats und der Primärbereiche entspricht; und

   (c) einen ersten (22) und einem zweiten (24) Sekundärbereich, die in dem Substrat ausgebildet sind und sich von der Hauptfläche neben dem ersten beziehungsweise dem zweiten Primärbereich erstrecken und zwischen sich den Kanalbereich begrenzen, wobei die Sekundärbereiche von demselben Leitfähigkeitstyp sind wie die Primärbereiche und eine zweite Umkehr-Durchbruchsspannung aufweisen, die den jeweiligen Leitfähigkeiten des Substrats und der Sekundärbereiche entspricht, wobei die Sekundärbereiche jeweils eine Dotierungsdichte auf weisen, die geringer ist als die der Primärbereiche und wobei die zweite Durchbruchsspannung höher ist als die erste Durchbruchsspannung; wobei sich der erste und der zweite Sekundärbereich von der Hauptfläche im wesentlichen in die gleiche Übergangstiefe erstrecken wie der erste und der zweite Primärbereich erstrecken,

   dadurch gekennzeichnet, daß die jeweiligen Dotierungsdichten der Sekundärbereiche und des Kanalbereichs derart sind, daß wenigstens einer der Transistoren ein Kurzkanaltransistor mit einer ersten Kanallänge im Bereich zwischen 0,75 µm und 1,5 µm und wenigstens ein anderer der Transistoren ein Langkanaltransistor mit einer zweiten Kanallänge ist, die größer als die erste Kanallänge ist und im Bereich zwischen 1,5 µm und 3,0 µm liegt, wobei die Dotierungsdichte in den Sekundärbereichen der Langkanaltransistoren geringer ist als die Dotierungsdichte in den Sekundärbereichen der Kurzkanaltransistoren.

2. Integrierte Schaltung nach Anspruch 1, bei der die Dotierungsdichte der Sekundärbereiche ungefähr eine bis drei Größenordnungen geringer ist als die der Primärbereiche.

3. Integrierte Schaltung nach Anspruch 1 oder 2, dadurch gekennzeichnet, daß die Gate-Oxidschicht eine Dicke von weniger als 50 nm hat.

4. Integrierte Schaltung nach Anspruch 3, dadurch gekennzeichnet, daß die Gate-Oxidschicht eine Dicke von weniger als 30 nm hat.

5. Verfahren zur Herstellung einer integrierten Schaltung nach einem der vorhergehenden Ansprüche, wobei das Verfahren die folgenden Schritte umfaßt: Bilden von einen Oberflächenbereich des Substrats überlagernden Gatestrukturen umfaßt, wobei jede der Gatestrukturen eine Gateelektrode (38, 38', 40, 40'), welche einen Kanalbereich (34) in dem Substrat bildet, und eine zwischen der Gateelektrode und der Hauptfläche angeordnete Gate-Oxidschicht (46) aufweist;

   (a) Implantieren eines ersten Dotanden (4, 88) eines zweiten Leitfähigkeitstyps zur Bildung leicht dotierter Sekundärbereiche (90, 94) für jeden Transistor, wobei sich die leicht dotierten Bereiche jeweils von der Hauptfläche aus bis in eine vorbestimmte Tiefe zwischen 0,2 und 0,8 µm erstrecken und jeweils voneinander durch einen den Kanalbereich (34, 36) enthaltenden zwischen ihnen liegenden Bereich des Substrats (12) beabstandet sind, wobei die leicht dotierten Bereiche mit den Rändern der jeweiligen Gatestrukturen ausgerichtet sind und eine erste Umkehr-Durchbruchsspannung aufweisen, die der Leitfähigkeit der Bereiche relativ zu derjenigen des Substrats entspricht;

   (b) Bilden einer Randmaske (96), die an die Ränder der Gatemaske angrenzt und sich über diese hinaus erstreckt, um jeweilige Bereiche der leicht dotierten Sekundärbereiche (90, 94) zu überlagern; und

   (c) Implantieren eines zweiten Dotanden (100, 108) in den unmaskierten Bereichen der leicht dotierten Sekundärbereiche zur Bildung dichter dotierter Primärbereiche (108, 104) in dem Substrat (12), welche die gleiche Erstreckung wie jeweilige Bereiche der leicht dotierten Sekundärbereiche (90, 94), wobei die Primärbereiche (108, 104) voneinander beabstandet und mit jeweiligen Rändern der Randmaske (96) ausgerichtet sind und sich jeweils bis in die vorbestimmte Tiefe unterhalb der Hauptfläche erstrecken;

wobei die jeweiligen Dotierungsdichten der leicht dotierten Sekundärbereiche (90, 94) und des Kanalbereichs derart sind, daß wenigstens einer der Transistoren ein Kurzkanaltransistor mit einer ersten Kanallänge im Bereich zwischen 0,75 µm und 1,5 µm und wenigstens ein anderer der Transistoren ein Langkanaltransistor mit einer zweiten Kanallänge ist, die größer als die erste Kanallänge ist und im Bereich zwischen 1.5 µm und 3,0 µm liegt, wobei eine erhöhte Dotierungsdichte in den Sekundärbereichen der Kurzkanaltransistoren erreicht wird, indem die Langkanaltransistorbereiche maskiert werden, während ein Dotand des zweiten Leitfähigkeitstyps in die Sekundärbereiche der Kurzkanaltransistorbereiche vor dem Implantieren des ersten Dotanden implantiert wird.

**6.** Verfahren nach Anspruch 5, dadurch gekennzeichnet, daß die die leicht dotierten Sekundärbereiche überlagernde Randmaske sich in einem Ausmaß zwischen ungefähr 0,25 bis 0,75 Mikrometer über die Ränder der Gatemaske hinaus erstreckt.

**7.** Verfahren nach Anspruch 5 oder 6, dadurch gekennzeichnet, daß das Substrat eine Hintergrund-Dotierungsdichte vom p-Leitfähigkeitstyp von ungefähr $8 \times 10^{14}/cm^{-3}$ oder eine Dotierungsdichte vom n-Leitfähigkeitstyp von ungefähr $8 \times 10^{15}/cm^{-3}$ aufweist.

## Revendications

**1.** Un circuit intégré comprenant une pluralité de transistors à effet de champ formés sur un substrat (12) d'un matériau semi-conducteur d'un premier type de conductivité, ledit substrat ayant une surface majeure, chaque transistor comprenant :

(a) une structure de grille recouvrant ladite surface majeure, ladite surface de grille comportant une électrode de grille (38, 38', 40, 40') délimitant une zone de canal (34) au sein dudit substrat, et une couche d'oxyde de grille (46) disposée entre ladite électrode de grille et ladite surface majeure ;
(b) une première (18), et une seconde (20) zones primaires formées dans le substrat et s'étendant à partir de ladite surface majeure et espacées respectivement l'une de l'autre par une portion intermédiaire dudit substrat comportant ladite zone de canal, lesdites zones primaires étant d'un second type de conductivité et ayant une première tension inverse de claquage correspondant aux conductivités relatives dudit substrat et desdites zones primaires ; et
(c) une première (22) et une seconde (24) zones secondaires formées dans ledit substrat et s'étendant à partir de ladite surface majeure, contigües respectivement auxdites première et seconde zones primaires et y délimitant ladite zone de canal entre celles-ci, lesdites zones secondaires étant du même type de conductivité que lesdites zones primaires et ayant une seconde tension inverse de claquage correspondant aux conductivités relatives dudit substrat et desdites zones secondaires, lesdites zones secondaires ayant respectivement une densité de dopage inférieure à celle desdites zones primaires et ladite seconde tension de claquage étant supérieure à ladite première tension de claquage ; lesdites première et seconde zones secondaires s'étendent à partir de ladite surface majeure jusqu'à une profondeur de jonction sensiblement égale à celle desdites première et seconde zones primaires, caractérisé en ce que les densités de dopage respectives desdites zones secondaires et de ladite zone de canal sont telles qu'au moins un des transistors est un transistor à canal court comprenant une première longueur de canal dans le domaine 0,75 µm-1,5 µm, et en ce qu'au moins un des autres transistors est un transistor à canal long présentant une deuxième longueur de canal supérieur à la première longueur de canal et du domaine 1,5-3,0 µm, la densité de dopage dans les zones secondaires des transistors à canal long étant inférieure à la densité de dopage dans les zones secondaires de transistors à canal courts.

**2.** Un circuit intégré conforme à la revendication 1, dans lequel la densité de dopage des zones secondaires est de 1 à 3 ordres de grandeur inférieure à celle des zones primaires.

**3.** Un circuit intégré conforme à l'une quelconque des revendications 1 et 2, caractérisé en ce que ladite couche d'oxyde de grille a une épaisseur inférieure à 50 nm.

4. Un circuit intégré conforme à la revendication 3, caractérisé en ce que ladite couche d'oxyde de grille a une épaisseur inférieure à 30 nm.

5. Un procédé de fabrication d'un circuit intégré selon l'une quelconque des revendications précédentes ledit procédé comprenant

- la formation de structures de grille par-dessus la surface majeure dudit substrat, chaque structure de grille comprenant une électrode de grille (38, 38', 40, 40') définissant une zone de canal (34, 36) dans ledit substrat et une couche d'oxyde de grille (46) disposée entre ladite électrode de grille et ladite surface majeure
- l'apport d'un premier agent de dopage (84, 88) d'un second type de conductivité pour former des zones secondaires (90, 94) légèrement dopées pour chaque transistor, les zones légèrement dopées s'étendant sous la surface majeure sur une profondeur prédéterminée comprise entre 0,2 et 0,8 micron, et étant respectivement espacées l'une de l'autre par une partie intermédiaire dudit substrat (12) comprenant ladite zone de canal (34, 36), les zones légèrement dopées étant alignées par rapport aux bords des structures de grilles respectives et présentant une première tension de claquage inverse correspondant à la conductivité desdites zones par rapport audit substrat ;
- la formation d'un masque de bordure (96) bordant et s'étendant au delà des bords de la structure de grille afin de recouvrir les portions respectives desdites zones légèrement dopées (90, 94) ; et
- l'apport d'un deuxième agent de dopage (100, 108) dans les portions non masquées desdites zones secondaires légèrement dopées pour former des zones primaires plus fortement dopées (108, 104) dans le substrat (12) s'étendant conjointement à des portions respectives desdites zones secondaires légèrement dopées (90, 94), les zones primaires (108, 104) étant espacées l'une de l'autre et alignées sur les bords respectifs dudit masque de bordure (96) et s'étendant respectivement sous la surface majeure environ jusqu'à ladite profondeur prédéterminée,
- les densités de dopages respectives des zones secondaires légèrement dopées (90, 94) et la zone de canal étant telles qu'au moins un des transistors est un transistor à canal court présentant une première longueur de canal du domaine 0,75 µm-1,5 µm et qu'au moins un autre des transistors est un transistor à canal long présentant une deuxième longueur de canal supérieur à la première longueur de canal et du domaine 1,5 µm-3,0 µm, une densité de dopage renforcée étant obtenue dans les zones secondaires des transistors à canal court, par un masquage des zones de transistor à canal long et une implantation d'un dopant du deuxième type de conductivité dans les zones secondaires des zones de transistor à canal court avant l'implantation dudit premier dopant.

6. Le procédé de la revendication 5, caractérisé en ce que ledit masque de bordure recouvrant lesdites zones secondaires légèrement dopées s'étend au-delà des bords dudit masque de grille d'environ 0,25 à 0,75 micron.

7. Le procédé de l'une quelconque des revendications 5 et 6, caractérisé en ce que ledit substrat a une densité de dopage du fond d'une conductivité de type P d'environ $8 \times 10^{14}$ cm$^{-3}$ ou une densité de dopage d'une conductivité de type N d'environ $8 \times 10^{15}$ cm$^{-3}$.

EP 0 228 815 B2

FIG. 1

FIG. 2

FIG. 3

FIG. 4

FIG. 5

FIG. 6

FIG. 7

FIG. 8

FIG. 9

FIG. 10